# EUROPEAN PATENT APPLICATION

(11) **EP 1 946 938 A1**
(43) Date of publication of application: **23.07.2008**
(21) Application number: 06811430.5
(22) Date of filing: 06.10.2006
(51) Int. Cl.: B41N 1/12, B41C 1/00, B41C 1/045, B41C 1/18, B41N 1/22, C23C 14/06, C23C 28/00

(54) **GRAVURE PRINTING ROLL AND METHOD FOR MANUFACTURE THEREOF**

(30) Priority: 14.10.2005 JP 2005300629
(71) Applicant: THINK LABORATORY CO., LTD., Chiba, 227-8525 (JP)
(72) Inventor: SHIGETA, Tatsuo, Kashiwa-shi, Chiba 277-8525 (JP)
(74) Representative: Grünecker, Kinkeldey, Stockmair & Schwanhäusser Anwaltssozietät
(86) International application number: PCT/JP2006/320103
(87) International publication number: WO 2007/043471

(57) **Abstract**

Disclosed is a novel gravure printing roll which has no toxicity, causes no deterioration of the environment, has a surface-reinforcing coating layer and is excellent in print durability and printing performance. Also disclosed is a method of manufacturing of the gravure printing roll. The gravure printing roll includes a hollow roll, a copper plating layer which is formed on a surface of the hollow roll and has a large number of gravure cells, and a diamond-like carbon coating layer covering the surface of the copper plating layer, in which each of the gravure cells coated with the diamond-like carbon coating layer has a depth of 5 µm or more and less than 10 µm.

## Description

### Technical Field

The present invention relates to a gravure printing roll having a surface-reinforcing coating layer with sufficient hardness and having gravure cells with extremely shallow depths without using chromium plating, and a method of manufacturing the same. More particularly, the present invention relates to a gravure printing roll which is provided with a diamond-like carbon (DLC) layer as a surface-reinforcing coating layer in place of a chromium layer and has achieved sufficient printing densities (optical density, transmittance density) and hiding properties in gravure printing, and a method of manufacturing the same.

### Background Art

As a conventional gravure printing roll, a plate which has 175 screen lines per inch and whose depths of cells in maximum shadow parts are 25 µm to 30 µm is generally used. Gravure printing is performed using a gravure ink containing an inorganic pigment and an organic pigment in which 90% or more of the particles contained therein have diameters of 2 or 3 µm or more.

The basic composition of ink is composed of four components: a pigment for imparting color to an ink, as a main agent; a resin which fixes the pigment to a target to be printed and disperse the pigment uniformly; a vehicle which is a solvent for adjusting the fluidity, transferability, drying property, etc., of ink; and an additive as an assistant agent, for imparting various effects such as antifoaming effect and antistatic effect.

As a solvent for an oil-based ink, toluene, xylene, ethyl acetate, n-propyl acetate, MEK, MIBK, IPA, ethanol, n-propanol, etc. are used, and, as a solvent for a water-based ink, ethanol, n-propanol, IPA, and water are used.

Chemical substances used in an oil-based ink such as toluene and MEK have the following disadvantages: (1) such substances have strong irritating odor; (2) because the flash point is low and the volatility is high, ignition and explosion are likely to occur when filled with the substances; (3) when sucked into a human body, health hazards occur; (4) the environment is also adversely affected; (5) such substances have negative influence on the reduction of the emission amount of CO₂.

Organic compounds (VOC), such as a solvent and the like, which evaporate during printing have the following disadvantages: (1) when such organic compounds are discharged from a plant to the outside, air pollution or an offensive odor problem around plants occurs; (2) when a plant is filled with such organic compounds, which cannot be completely discharged and remained in the plant, it causes dangers in the working environment, such as dangers of ignition and explosion, and health hazards for workers; and (3) a solvent which does not completely evaporate and remains in a film causes odor peculiar to a printed bag, which is problematic especially in the food industry.

The residual solvent problem not only degrades the image of goods but also, in the case of foods, impairs the flavor or change the taste when the food is easy to absorb a smell.

Although water-based inks have solved various problems of oil-based inks by basically using water and alcohol, there remains a problem in that ethanol remains. However, a mixture of ethanol and water does not have a strong irritating odor and does not change the flavor of the contents. The influence of ethanol is much lower than the tolerance level in which ethanol adversely effects on the environment and health. The inside of a plant is filled with ethanol, but there is almost no smell. However, because ethanol is an alcohol, ethanol is not completely free from a risk of ignition, but the risk is much lower when compared with the case of an organic solvent.

As a gravure plate manufactured by a conventional laser plate-making, a plate which has 175 screen lines per inch and whose depths of cells in maximum shadow parts are 25 µm to 30 µm is generally used. When a water-based gravure printing is performed under the conditions, the drying rate of ink is low, resulting in that fogging is likely to occur. Because the drying rate of ink is low, the printing speed needs to be reduced as compared with that of gravure printing using an oil-based ink, resulting in poor printing efficiency (production efficiency).

A plate for use in the water-based gravure printing has features that the cells are shallow and there are a large number of screen lines so that the drying rate of ink increases as compared with an oil-based gravure printing. Due to the features, printing whose texture is different from that obtained by the oil-based gravure printing is achieved. In general, color tones are brighter, halftone dot reproducibility (minute portions) is improved, and highlight properties are improved. Thus, the amount of ink decreases by reducing the thickness of a plate, whereby the influence of a solvent further decreases due to the reduced amount of ink. Patent Documents 9 and 10 propose using a gravure printing method employing a water-based gravure ink and a plate having 200 to 400 mesh lines and a depth of 10 to 17 µm.

Further, in gravure printing, minute concave portions (gravure cells) according to plate-making information are formed in a gravure printing roll (gravure cylinder) to produce a printing plate, and ink is placed in the gravure cells, thereby transferring an image to a printing target. In a general gravure printing roll, a copper plating layer (printing material) for forming a printing plate is formed on the surface of a hollow roll formed of metal such as aluminum and iron; many minute concave portions (gravure cells) are formed according to plate-making information in the copper plating layer by etching; and then a hard chromium layer is formed by chromium plating for increasing the printing durability of a gravure printing roll to obtain a surface-reinforcing coating layer, whereby plate-making (production of a printing plate) is completed. However, because hexavalent chromium with high toxicity is used in chromium plating, extra cost is required for maintaining safe operations and a problem of pollution arises. Therefore, in the present circumstances, development of a surface-reinforcing coating layer in place of a chromium layer is desired.

In contrast, with respect to production of a gravure printing roll (gravure cylinder), a technology of forming a diamond-like carbon (DLC) on a copper plating layer, in which cells are formed, and using the same as a surface-reinforcing coating layer is known (Patent Documents 1 to 3), and a technology of forming a DLC layer on a copper plating layer, and then forming cells, thereby producing a printing plate (Patent Document 4) are known. However, there is a problem that the adhesion of the DLC layer with copper is weak, and thus the DLC layer is likely to separate. The applicant of this application already proposes a technology of forming a rubber or resin layer on a hollow roll, forming a diamond-like carbon (DLC) coating thereon, followed by forming cells and producing a gravure printing plate (Patent Documents 5 to 7).
Patent Document 1: JP 04-282296 A
Patent Document 2: JP 2002-172752 A
Patent Document 3: JP 2000-10300 A
Patent Document 4: JP 2002-178653 A
Patent Document 5: JP 11-309950 A
Patent Document 6: JP 11-327124 A
Patent Document 7: JP 2000-15770 A
Patent Document 8: JP 2003-145952 A
Patent Document 9: JP 2001-30611 A
Patent Document 10: JP 2002-178622 A

### Disclosure of the Invention

### Problems to be solved by the Invention

In view of the above-mentioned problems of the conventional technology, the inventors of the present invention continued extensive studies on a surface-reinforcing coating layer in place of a chromium plating layer. As a result, the inventors found that the use of a thin layer (e.g., 1 µm thick) of diamond-like carbon (DLC) makes it possible to manufacture a surface-reinforcing coating layer which has hardness equivalent to that of a thick layer (e.g., 8 µm) of chromium plating, does not have toxicity, and is free from the anxiety of pollution.

Moreover, the inventors of the present invention found that: the use of the thin film (e.g., 1 µm) of diamond-like carbon (DLC) makes it possible to easily manufacture a gravure printing roll with gravure cells having shallow depths; by printing using the gravure printing roll having gravure cells with shallow depths, necessary printing densities (optical density, transmittance density) can be secured; high-definition gravure printing can be achieved; hiding properties can be improved; the film thickness of ink is small and therefore the drying load is small, whereby the printing speed can be increased; a fogging problem can be overcome; and the amount of ink is reduced, whereby the printing cost can be reduced. Based on these findings, the present invention has been accomplished.

The present invention aims to provide: a novel gravure printing roll which has no toxicity, is free from the anxiety of pollution, has a surface-reinforcing coating layer, is excellent in printing durability, and is excellent in printing performance; and a method of producing the same.

### Means for solving the Problems

In order to solve the above-mentioned problems, a gravure printing roll according to a first aspect of the present invention includes: a hollow roll; a copper plating layer which is formed on a surface of the hollow roll and a surface of which has a large number of gravure cells; and a diamond-like carbon coating layer covering the surface of the copper plating layer, in which a depth of the gravure cell coated with the diamond-like carbon coating layer is 5 µm or more and less than 10 µm.

A gravure printing roll according to a second aspect of the present invention includes: a hollow roll; a copper plating layer which is formed on a surface of the hollow roll and a surface of which has a large number of gravure cells; a metal layer formed on a surface of the copper plating layer; a metal carbide layer formed on a surface of the metal layer, the metal of the metal carbide being of the same metal as that of the metal layer; and a diamond-like carbon coating layer covering a surface of the metal carbide layer, in which a depth of the gravure cell coated with the diamond-like carbon coating layer is 5 µm or more and less than 10 µm.

A method of manufacturing a gravure printing roll according to a first aspect of the present invention includes the steps of: preparing a hollow roll; forming a copper plating layer on a surface the hollow roll; forming a large number of gravure cells on a surface of the copper plating layer; and forming a diamond-like carbon coating layer on the surface of the copper plating layer, in which a depth of the gravure cell coated with the diamond-like carbon coating layer is 5 µm or more and less than 10 µm.

A method of manufacturing a gravure printing roll according to a second aspect the present invention includes the steps of: preparing a hollow roll; forming a copper plating layer on a surface of the hollow roll; forming a large number of gravure cells on a surface of the copper plating layer; forming a metal layer on the surface of the copper plating layer; forming a metal carbide layer on a surface of the metal layer, the metal of the metal carbide being of the same metal as that of the metal layer; and forming a diamond-like carbon coating layer covering a surface of the metal carbide layer, in which a depth of the gravure cell coated with the diamond-like carbon coating layer is 5 µm or more and less than 10 µm.

It is preferred that the metal carbide layer be a metal carbide inclined layer, and a composition ratio of carbon in the metal carbide inclined layer be set so that a proportion of carbon increases gradually in a direction of the diamond-like carbon coating layer from the metal layer side. The adhesion of the diamond-like carbon coating layer to the copper plating layer is improved by providing the metal layer and the metal carbide layer therebetween.

It is preferred that a thickness of the copper plating layer be 50 to 200 µm, a thickness of the metal layer be 0.001 to 1 µm, preferably 0.001 to 0.05 µm, a thickness of the metal carbide layer be 0.1 to 1 µm, and a thickness of the diamond-like carbon coating layer be 0.1 to 2 µm. The depths of the gravure cells coated with the diamond-like carbon coating layer are 5 µm or more and less than 10 µm, preferably 6 µm or more and 9 µm or less, and more preferably, 7 µm or more and 8.5 µm or less. The thickness of the diamond-like carbon coating layer is 0.1 to 2 µm, preferably 0.5 to 1.5 µm, and more preferably 0.8 to 1.2 µm.

It is preferred that the metal layer, the metal carbide layer, preferably, the metal carbide inclined layer and the diamond-like carbon coating layer be formed by sputtering, respectively.

It is preferred to use the metal which is capable of being carbonated and has high compatibility with copper.

It is preferred that the metal be one kind or two or more kinds of metals selected from the group consisting of tungsten (W), silicon (Si), titanium (Ti), chromium (Cr), tantalum (Ta), and zirconium (Zr).

The gravure cells may be formed by an etching method or electronic engraving, and the etching method is preferable. The etching method involves applying a sensitizing solution to a plate body surface of a gravure cylinder, directly baking the resultant, and then etching the baked matter to thereby form gravure cells. The electronic engraving includes mechanically operating a diamond engraving needle by a digital signal, and engraving gravure cells on the surface of copper of a gravure cylinder.

### Effect of the Invention

According to the present invention, by the use of the diamond-like carbon (DLC) coating as the surface-reinforcing coating layer, a chromium plating process can be omitted. Therefore, the following excellent effects are obtained: there is no need to use hexavalent chromium with high toxicity, so an extra cost for safe operations is unnecessary; it is free from the anxiety of pollution; and moreover, the diamond-like carbon (DLC) coating has hardness equal to a chromium layer and excellent printing durability.

The diamond-like carbon (DLC) coating, even if it is a thin layer (e.g., 0.1 to 2 µm), has hardness equal to a thick chromium plating layer (e.g., 8 µm). Thus, the use of the thin film (e.g., 0.1 to 2 µm) of diamond-like carbon (DLC) makes it possible to easily manufacture a gravure printing roll with gravure cells having shallow depths; by printing using the gravure printing roll having gravure cells with shallow depths, necessary printing densities (optical density, transmittance density) can be secured; high-definition gravure printing can be achieved; hiding properties can be improved; the film thickness of ink is small and therefore the drying load is small, whereby the printing speed can be increased; a fogging problem can be overcome; and the amount of ink is reduced, whereby the printing cost can be reduced. Moreover, when using an oil-based ink, an excellent effect can be achieved that the emission amount of VOC can be sharply reduced.

### Brief Description of the Drawings

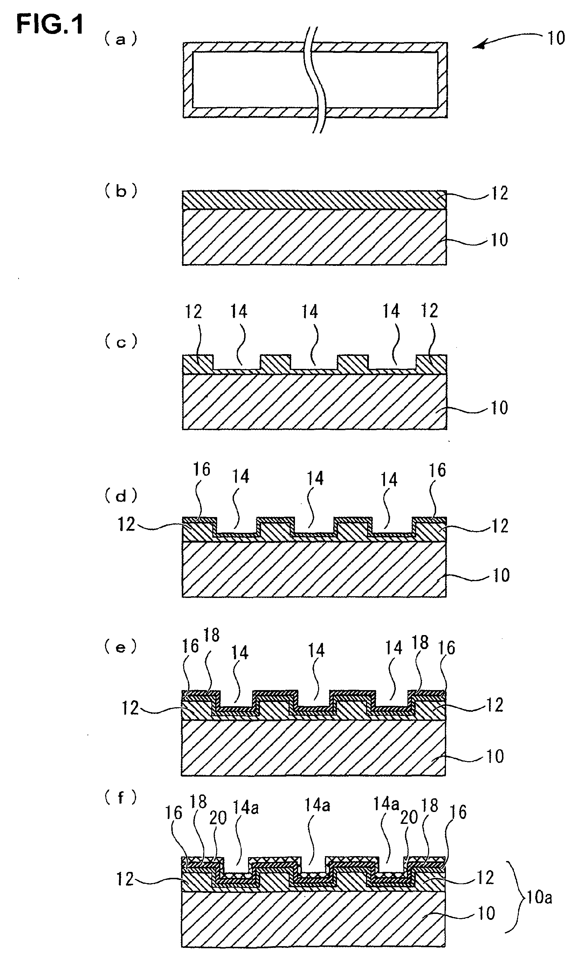

FIG. 1 is an explanatory diagram schematically illustrating a process of manufacturing a gravure printing roll of the present invention, in which: part (a) is an entire cross-sectional view of a hollow roll; part (b) is a partial enlarged cross-sectional view illustrating a state in which a copper plating layer is formed on the surface of the hollow roll; part (c) is a partial enlarged cross-sectional view illustrating a state in which gravure cells are formed on the copper plating layer of the hollow roll; part (d) is a partial enlarged cross-sectional view illustrating a state in which a tungsten carbide layer is formed on the surface of the copper plating layer of the hollow roll; part (e) is a partial enlarged cross-sectional view illustrating a state in which a metal carbide layer is formed on the surface of the metal layer of the hollow roll; and part (f) is a partial enlarged cross-sectional view illustrating a state in which a diamond-like carbon (DLC) coating covers the surface of the metal carbide layer of the hollow roll.
FIG. 2 is a flowchart illustrating a method of manufacturing a gravure printing roll of the present invention.
FIG. 3 is an enlarged cross-sectional view of a main portion of the gravure printing roll of the present invention.
FIG. 4 is a cross-sectional schematic view illustrating the formation of a gravure cell according to an aspect, in which: part (a) illustrates a case where coating is performed by a diamond-like carbon (DLC) coating; and part (b) illustrates a case where coating is performed by a conventional chromium plating layer.
FIG. 5 is a top view of FIG. 4, in which: part (a) is a top view of FIG. 4(a); and part (b) is a top view of FIG. 4(b).
FIG. 6 is a cross-sectional schematic view illustrating the formation of a gravure cell according to another aspect, in which: part (a) illustrates a case where coating is performed by a diamond-like carbon (DLC) coating of the present invention; and part (b) illustrates a case where coating is performed with a conventional chromium plating layer.
FIG. 7 is a cross-sectional schematic view illustrating the formation of a gravure cell according to still another aspect in which coating is performed by a diamond-like carbon (DLC) coating of the present invention.

### Description of Reference Symbols

10: a plate base material (hollow roll), 10a: an gravure printing roll, 11: ink, 12: a copper plating layer, 13, 13a, 13b: partition sections, 14: a gravure cell, 14a: a gravure cell covered with a DLC coating layer, having a configuration according to the present invention, 14b: a gravure cell covered with a chromium plating layer, having a conventional configuration, 16: a metal layer, 18: a metal carbide layer, preferably, a metal carbide inclined layer, 20: a diamond-like carbon (DLC) coating layer, 21: chromium plating layer

### Best Mode for carrying out the Invention

Hereinafter, an embodiment of the present invention will be described. Illustrated examples are shown for illustrative purposes and, it goes without saying that they can be modified variously as long as they do not deviate from the technical idea of the present invention.

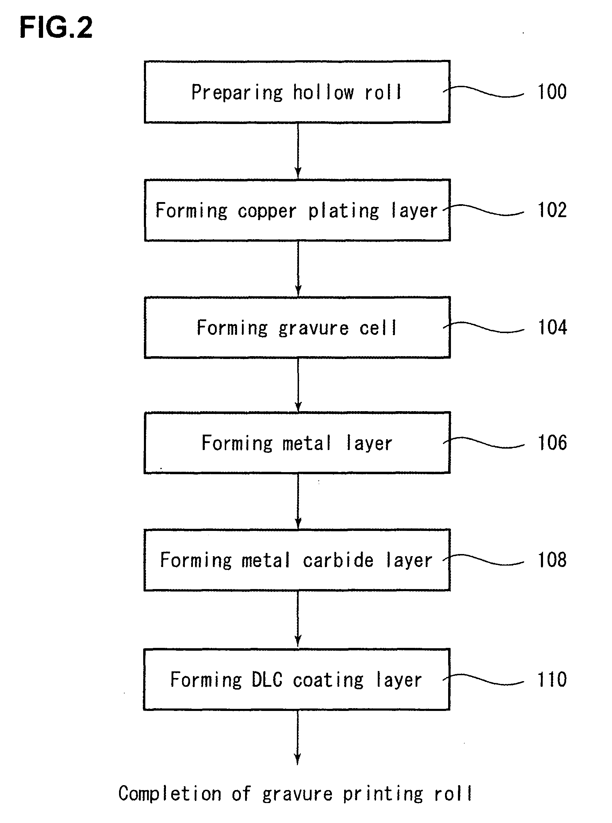

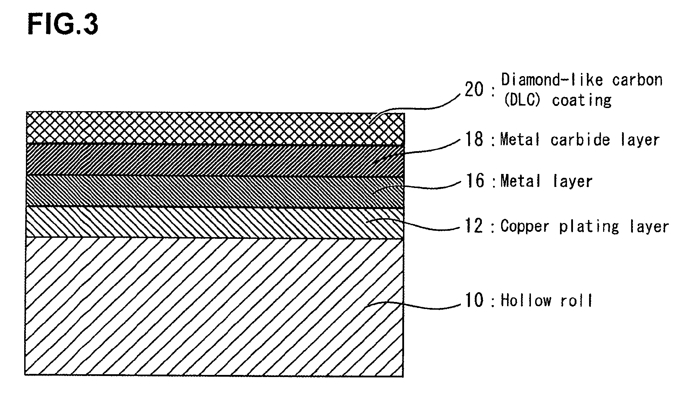

FIG. 1 is an explanatory diagram schematically illustrating a process of manufacturing a gravure printing roll of the present invention: part (a) is an entire cross-sectional view of a hollow roll; (b) is a partial enlarged cross-sectional view illustrating a state in which a copper plating layer is formed on the surface of the hollow roll; part (c) is a partial enlarged cross-sectional view illustrating a state in which gravure cells are formed on the copper plating layer of the hollow roll; (d) is a partial enlarged cross-sectional view illustrating a state in which a metal layer is formed on the surface of the copper plating layer of the hollow roll; (e) is a partial enlarged cross-sectional view illustrating a state in which a metal carbide layer is formed on the surface of the metal layer of the hollow roll; and (f) is a partial enlarged cross-sectional view illustrating a state in which a diamond-like carbon (DLC) coating layer covers the surface of the metal carbide layer of the hollow roll. FIG. 2 is a flowchart illustrating a method of manufacturing a gravure printing roll of the present invention. FIG. 3 is an enlarged cross-sectional view of a main portion of the gravure printing roll of the present invention.

The method of the present invention will be described with reference to FIGS. 1 to 3. In FIGS. 1(a) and 3, reference numeral 10 denotes a plate base material, and hollow roll made of a metal such as aluminum or iron, or a reinforced resin such as carbon fiber-reinforced plastic (CFRP) is used (Step 100 of FIG. 2). A copper plating layer 12 is formed on the surface of the hollow roll 10 by copper plating (Step 102 of FIG. 2).

On the surface of the copper plating layer 12, a number of minute concave portions (gravure cells) 14 are formed (Step 104 of FIG. 2). As a method of forming the gravure cells 14, a known method can be used, such as etching (coating a plate body surface with a sensitizing solution to perform direct burning, followed by etching, thereby forming the gravure cells 14) or electronic engraving (mechanically operating a diamond engraving needle with a digital signal to engrave the gravure cells 14 on the surface of copper), and etching is preferable.

Next, on the surface of the copper plating layer 12 (including the gravure cells 14) with the gravure cells 14 formed thereon, a metal layer 16 is formed (Step 106 of FIG. 2). Further, a metal carbide layer of the metal, preferably a metal carbide inclined layer 18, is formed on the surface of the metal layer 16 (Step 108 of FIG. 2). As a method of forming the metal layer 16 and the metal carbide layer, preferably, the metal carbide inclined layer 18, known methods such as a sputtering method, a vacuum deposition method (an electron beam method), an ion plating method, a molecular beam epitaxy method (MBE), a laser abrasion method, an ion assist film-formation method, or a plasma CVD method can be applied, and the sputtering method is preferable.

As the metal, a metal capable of being carbonated and having high compatibility with copper is preferable. As the metal, it is possible to use tungsten (W), silicon (Si), titanium (Ti), chromium (Cr), tantalum (Ta), and zirconium (Zr).

As the metal in the metal carbide layer, preferably the metal carbide inclined layer 18, the same metal as that of the metal layer 16 is used. The composition ratio of carbon in the metal carbide inclined layer 18 is set so that the proportion of carbon increases gradually from the metal layer 16 side in the direction of a diamond-like carbon (DLC) coating layer 20 described later. That is, film formation is performed so that the composition ratio of carbon increases gradually in a proportion from 0% (in stages or in non-stages) to finally reach about 100%.

In this case, as a method of adjusting the composition ratio of carbon in the metal carbide layer, preferably the metal carbide inclined layer 18, a known method may be used. For example, the metal carbide layer (i.e., the metal carbide inclined layer 18) can be formed, in which the composition ratios of carbon and metal are changed so that the proportion of carbon in the metal carbide layer 18 increases gradually by stages or by non-stages in the direction of the diamond-like carbon (DLC) coating layer 20 side from the copper plating layer 12 side, by, for example, sputtering (the injection amount of hydrocarbon gas such as methane gas, ethane gas, propane gas, butane gas, or acetylene gas increases gradually in stages or in non-stages in an argon gas atmosphere, using a solid metal target).

By adjusting the proportion of carbon in the metal carbide layer 18, the adhesion of the metal carbide layer 18 with respect to both the metal layer 16 and the diamond-like carbon (DLC) coating layer 20 can be enhanced. Further, if the injection amount of hydrocarbon gas is set to be constant, a metal carbide layer in which the composition ratios of carbon and metal are set to be constant can be formed, and the metal carbide layer thus obtained is allowed to function similarly to that of the metal carbide inclined layer.

Then, on the surface of the metal carbide layer, preferably, of the metal carbide inclined layer 18, the diamond-like carbon (DLC) coating layer 20 is formed so as to cover the surface of the metal carbide layer (Step 110 of FIG. 2). As a method of forming the diamond-like carbon (DLC) coating layer 20, in the same way as in the formation of the metal layer 16 and the metal carbide layer, preferably, the metal carbide inclined layer 18, a known method such as a sputtering method, a vacuum deposition method (an electron beam method), an ion plating method, a molecular beam epitaxy method (MBE), a laser abrasion method, an ion assist film formation method, or a plasma CVD method can be applied, and the sputtering method is preferable.

The above-mentioned diamond-like carbon (DLC) coating layer 20 is covered, and is allowed to function as a surface-reinforcing coating layer, whereby a gravure printing roll 10a excellent in printing durability without toxicity and any possibility of the occurrence of pollution can be obtained.

Herein, according to the sputtering method, ions are allowed to strike a material (target material) desired to be a thin film, the material is sputtered, and the sputtered material is deposited on a substrate to produce a thin film. The sputtering method is characterized, for example, in that there is no particular constraint to a target material, and a thin film can be produced with good reproducibility in a large area.

According to the vacuum deposition method (the electron beam method), a material desired to be a thin film is heated to be evaporated by the irradiation of electron beams, and the evaporated material adheres (is deposited) on a substrate to produce a thin film. The vacuum deposition method is characterized, for example, in that a film formation speed is high, and the damage to a substrate is small.

According to the ion plating mehod, a material desired to be a thin film is evaporated and ionized with a radio frequency (RF) (RF ion plating) or arc (arc ion plating), and deposited on a substrate to produce a thin film. The ion plating method is characterized, for example, in that a film formation speed is high, and adhesion strength is large.

The molecular beam epitaxy method is a method of evaporating a raw material in an ultrasonic vacuum, and supplying the raw material to a heated substrate to form a thin film.

The laser abrasion method is a method of allowing a laser pulse increased in density to be incident upon a target to allow ions to be released, thereby forming a thin film on an opposed substrate.

The ion assist film formation method is a method of setting an evaporation source and an ion source in a vacuum container, and forming a film, using ions, supplementarily.

The plasma CVD method is a method of decomposing a material gas using the excitation of plasma, and allowing the material gas to be deposited by reaction on a substrate, for the purpose of forming a thin film at lower temperature upon conduction of CVD method under a reduced pressure.

Described in the above-mentioned embodiment is a configuration in which the metal layer 16 and the metal carbide layer 18 are interposed between the copper plating layer 12 and the diamond-like carbon coating layer 20 so that the adhesion of the diamond-like carbon coating layer increases. When the metal layer 16 and/or the metal carbide layer 18 are not formed, it is a matter of course that the operation effects of the present invention resulting from the formation of the diamond-like carbon coating layer 20 are achieved.

A feature of the present invention resides in that the depths of the gravure cells 14a coated with the diamond-like carbon (DLC) coating layers in the obtained gravure printing roll 10a are made extremely shallow as compared with those of conventional gravure cells. More specifically, the depths of the gravure cells of the present invention are 5 µm or more and less than 10 µm, preferably 6 µm or more and 9 µm or less, and still more preferably 7 µm or more and 8.5 µm or less. The formation of such extremely shallow gravure cells can be achieved due to an excellent feature that even if the diamond-like carbon coating layer is a thin layer (e.g., 0.1 to 2 µm), the hardness of the diamond-like carbon coating layer is equal to a conventional thick layer (e.g., 8 µm) of chromium plating. The realization of the gravure cells with such extremely shallow depths provides the following many advantages.

More specifically, by printing using the gravure printing roll having the gravure cells with shallow depths: necessary printing densities (optical density, transmittance density) can be secured; high-definition gravure printing can be achieved; hiding properties can be improved; the film thickness of ink is small and therefore the drying load is small, whereby the printing speed can be increased; a fogging problem can be overcome; and the amount of ink is reduced, whereby the printing cost can be reduced.

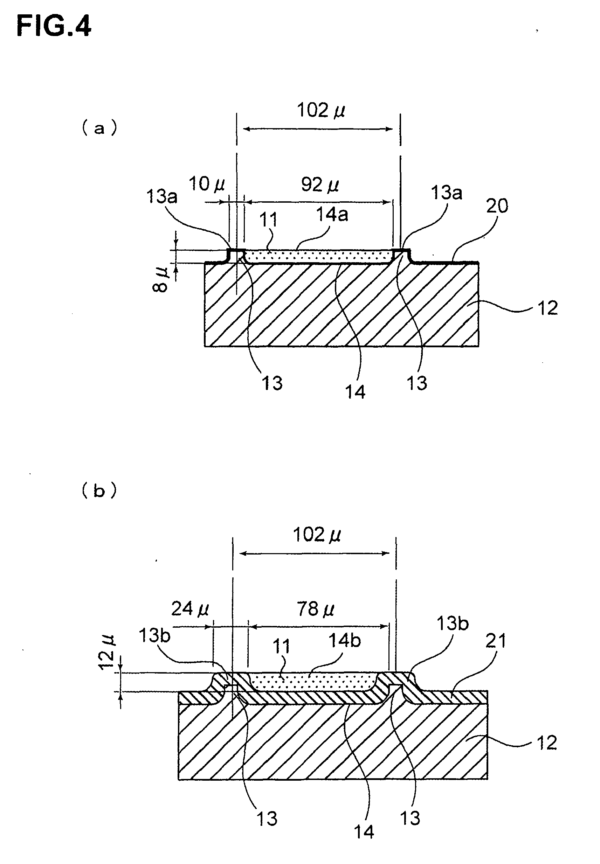

With reference to FIGS. 4 to 7, it will be described that a thin diamond-like carbon (DLC) coating layer (e.g., 1 µm) has an excellent configuration compared with a thick chromium plating coating layer (e.g., 8 µm) based on a comparison in the configuration of the gravure cells 14a between the conventional chromium plating coating layer (e.g., 8 µm) and the diamond-like carbon (DLC) coating layer (e.g., 1 µm) of the present invention.

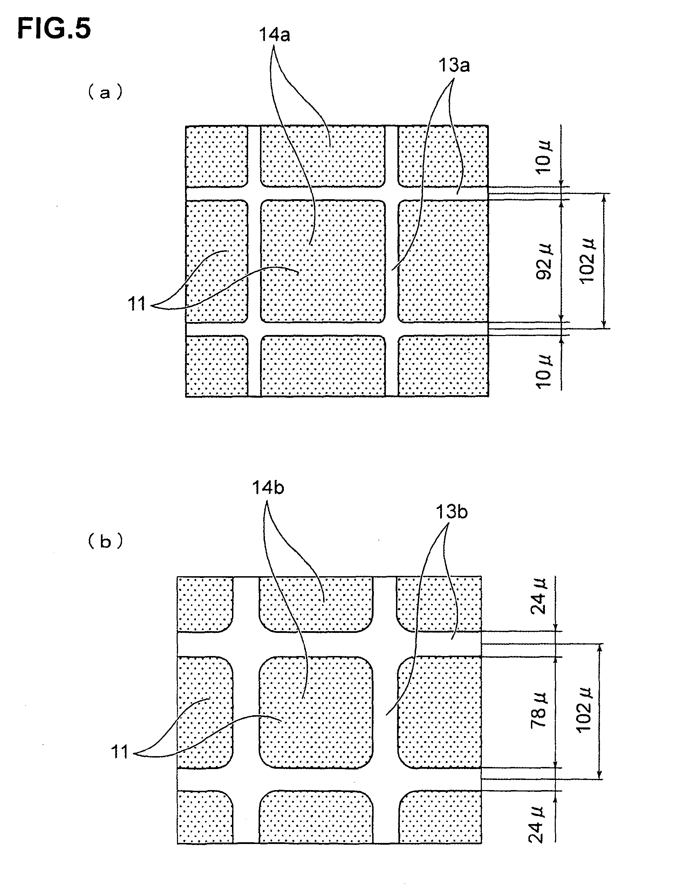

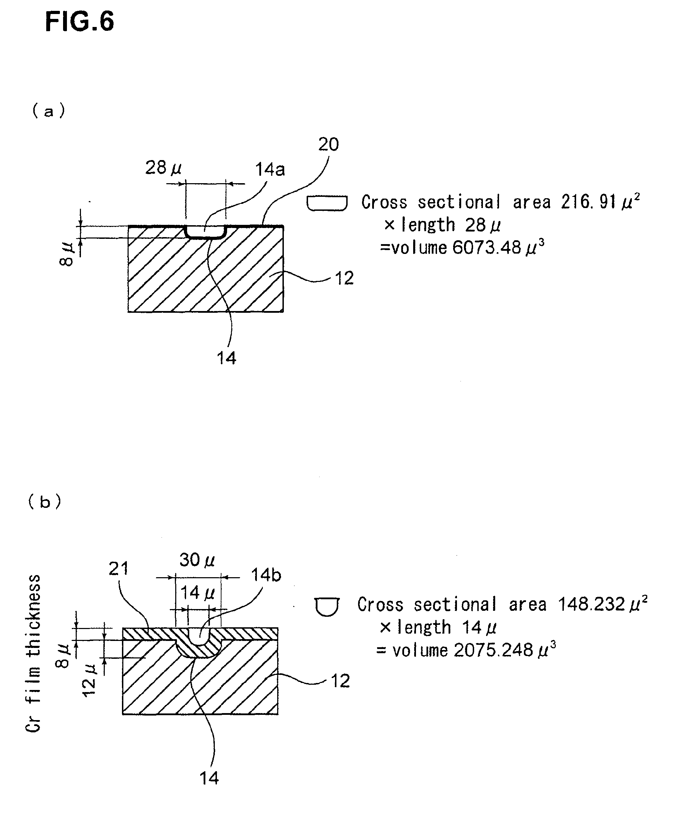

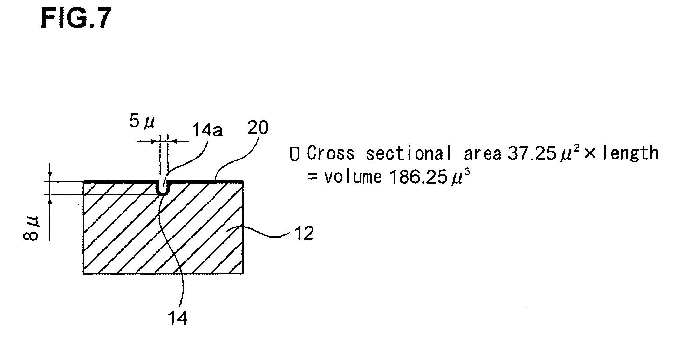

FIG. 4 is a cross-sectional schematic view illustrating the formation of a gravure cell according to an aspect, in which: part (a) illustrates a case where coating is performed by a diamond-like carbon (DLC) coating layer; and (b) illustrates a case where coating is performed by a conventional chromium plating layer. FIG. 5(a) is a top view of FIG. 4(a) and FIG. 5(b) is a top view of FIG. 4(b). FIG. 6 is a cross-sectional schematic view illustrating the formation of a gravure cell according to another aspect, in which: part (a) illustrates a case where coating is performed with a diamond-like carbon (DLC) coating layer of the present invention; (b) illustrates a case where coating is performed by a conventional chromium plating layer. FIG. 7 is a cross-sectional schematic view illustrating the formation of a gravure cell according to a still another aspect in which coating is performed by a diamond-like carbon (DLC) coating layer of the present invention. It is preferable that the metal layer 16 and the metal carbide layer 18 be provided between the copper plating layer 12 and the DLC coating layer 20. However, FIGS. 4(a), 5, 6(a), and 7 illustrate the configuration in which the above-mentioned layers are omitted.

In FIG. 4(b), the surface of the copper plating layer 12 is coated with a chromium (Cr) plating layer 21, resulting in the gravure cell 14b of the conventional configuration. The gravure cell 14b of the conventional configuration is formed by covering a bare gravure cell 12 (a bare partition 13: 8 µm thick, opening part: 94 µm x 94 µm and 12 µm depth) formed on the copper plating layer 12 with the chromium plating layer 21 having a thickness of 8 µm. The opening part of the gravure cell 14b of the conventional configuration thus formed has a dimension of 78 µm x 78 µm and has a depth of 12 µm. The thickness of the partition 13b coated with the chromium plating layer 21 is 24 µm (FIGS. 4(b) and 5(b)).

The cross sectional area illustrated in FIG. 4(b) is actually measured to be 914.9 µm². Then, a value obtained by multiplying the actual measurements of cross sectional area by a length (78 µm) is an actual measurement (71,362 µm³). Therefore, the ink 11 in an amount equivalent to the volume is stored in the gravure cell 14b.

In contrast, in FIG. 4(a), the surface of the copper plating layer 12 is coated with the diamond-like carbon (DLC) coating layer 20, resulting in formation of the gravure cell 14a of the present invention. The gravure cell 14a of the configuration according to the present invention is formed by covering the bare gravure cell 14 (a bare partition 13: 8 µm thick, opening part: 94 µm × 94 µm, depth: 8 µm) formed on the copper plating layer 12 with the diamond-like carbon (DLC) coating layer 20 having a thickness of 1 µm. The opening part of the gravure cell 14a of the configuration according to the present invention thus formed has a dimension of 92 µm × 92 µm and has a depth of 8 µm. The thickness of the partition 13a coated with the diamond-like carbon (DLC) coating layer 20 is 10 µm (FIGS. 4(a) and 6(a)).

The cross sectional area illustrated in FIG. 4(a) is actually measured to be 789.9 µm². Then, a value obtained by multiplying the actual measurement of cross sectional area by a length (92 µm) is an actual measurement (72,670 µm³). Therefore, the ink 11 in an amount equivalent to the volume is stored in the gravure cell 14a.

When the gravure cell 14b of the conventional configuration is compared with the gravure cell 14a of the configuration according to the present invention, both the gravure cells are the same in the area (102 µm × 102 µm) of the upper surface square measured from the center of the partition. The depth of the gravure cell 14b of the conventional configuration is 12 µm. In contrast, although the gravure cell 14a of the configuration according to the present invention has a depth as shallow as 8 µm, the ink 11 in an amount substantially equivalent to that of the conventional gravure cell 14b can be stored (a slightly larger amount of ink can be stored in the gravure cell 14a of the present invention). Therefore, the gravure cell 14a of the present invention can achieve printing density (optical density, transmittance density) equivalent to that of the conventional gravure cell 14b.

Moreover, as well illustrated in FIGS. 5(a) and (b), in the gravure cell 14a of the configuration according to the present invention, the thickness of the partition section 13a coated with the diamond-like carbon (DLC) coating layer 20 is 10 µm. The thickness of the partition section 13a is much smaller than the thickness (24 µm) of the partition section 13b of the gravure cell 14b of the conventional configuration, whereby ink loss during printing decreases and the hiding properties are extremely improved.

Moreover, by printing using the gravure cell 14a having the above-mentioned extremely shallow depth, the following advantages can be obtained: the film thickness of ink becomes small, and therefore the drying load is small, whereby the printing speed can be increased; a fogging problem can be overcome; and the ink amount can be reduced, whereby the printing cost can be reduced.

FIG. 6 illustrates gravure cells, in which FIG. 6(b) illustrates a gravure cell of the conventional configuration and FIG. 6(a) illustrates the formation of a gravure cell of the configuration according to another aspect of the present invention. The gravure cell 14b of the conventional configuration illustrated in FIG. 6(b) is formed by covering the bare gravure cell 14 (opening part: 30 µm x 30 µm, depth: 12 µm) formed on the copper plating layer 12 with the chromium plating layer 21 having a thickness of 8 µm. The opening part of the gravure cell 14b of the conventional configuration thus formed has a dimension of 14 µm x 14 µm and has a depth of 12 µm. The cross sectional area illustrated in FIG. 6(b) is actually measured to be 148.232 µm². Then, a value obtained by multiplying the actual measurement of cross sectional area by a length (14 µm) is an actual measurement (2075.248 µm³). Therefore, the ink in an amount equivalent to the volume is stored in the gravure cell 14b.

In contrast, the gravure cell 14a of the configuration according to the present invention illustrated in FIG. 6(a) is formed by covering the bare gravure cell 14 (opening part: 30 µm × 30 µm, depth: 8 µm) formed on the copper plating layer 12 with the diamond-like carbon (DLC) coating layer 20 having a thickness of 1 µm. The opening part of the gravure cell 14a of the configuration according to the present invention thus formed has a dimension of 28 µm × 28 µm and has a depth of 8 µm. The cross sectional area illustrated in FIG. 6(a) is actually measured to be 216.91 µm². Then, a value obtained by multiplying the actual measurement of cross sectional area by a length (28 µm) is an actual measurement (6073.48 µm³). Therefore, the ink in an amount equivalent to the volume is stored in the gravure cell 14a.

As is clear from the comparison between the gravure cell 14b of the conventional configuration described above and the gravure cell 14a of the configuration according to the present invention described above, by employing the gravure cell of the configuration according to the present invention, an advantage can be achieved that even if the opening part is small and the depth is made shallow, the storage amount of ink sharply increases compared with the case where the gravure cell of the conventional configuration is employed.

FIG. 7 illustrates the formation of the gravure cell of the configuration according to still another aspect of the present invention. The gravure cell 14a of the configuration according to the present invention illustrated in FIG. 7 has an extremely small opening part. The gravure cell 14a of the configuration according to the present invention is formed by covering the bare gravure cell 14 (opening part: 7 µm × 7 µm, depth: 8 µm) formed on the copper plating layer 12 with the diamond-like carbon (DLC) coating layer 20 having a thickness of 1 µm. The opening part of the gravure cell 14a of the configuration according to the present invention thus formed has a dimension of 5 µm x 5 µm and has a depth of 8 µm.

The cross sectional area illustrated in FIG. 7 is actually measured to be 37.25 µm². Then, a value obtained by multiplying the actual measurement of cross sectional area by a length (5 µm) is an actual measurement (186.25 µm³). Therefore, the ink in an amount equivalent to the volume is stored in the gravure cell 14a. According to the present invention, an advantage is achieved that the gravure cell 14a having such an extremely small opening part can be easily produced.

### Example

The present invention will be described more specifically by way of the following examples. It should be appreciated that these examples are shown merely for an illustrative purpose and should not be interpreted in a limiting manner.

### (Example 1)

A gravure cylinder (aluminum hollow roll) with a circumference of 600 mm and a roll length of 1,100 mm was placed in a plating bath. An anode chamber was brought close to the hollow roll up to 20 mm by an automatic sliding apparatus under a computer system to allow a plating solution to overflow to immerse the hollow roll completely, whereby a copper plating layer of 80 µm was formed at 18 A/dm² and 6.0 V. A plating time was 20 minutes, and no bumps and pits were generated on the plated surface. Thus, a uniform copper plating layer was obtained.

The copper plating layer thus formed was coated with a photosensitive film. An image was exposed to a laser to be developed, followed by burning, thereby forming a resist image. Then, dry etching such as plasma etching was conducted to engrave an image made of gravure cells. After that, a resist image was removed to prepare a printing plate. At this time, a hollow roll in which the depth of the gravure cell was 8 µm (Example 1) was produced.

On an upper surface of the copper plating layer with the gravure cells formed thereon, a tungsten (W) layer was formed by sputtering. The sputtering conditions were as follows. A tungsten (W) sample: a solid tungsten target, an atmosphere: an argon gas atmosphere, a film formation temperature: 200 to 300°C, a film formation time: 60 minutes, and a film formation thickness: 0.03 µm.

Next, a tungsten carbide layer was formed on the upper surface of the tungsten layer (W). The sputtering conditions were as follows. A tungsten (W) sample: a solid tungsten target, an atmosphere: hydrocarbon gas was increased gradually in an argon gas atmosphere, a film formation temperature: 200 to 300°C, a film formation time: 60 minutes, and a film formation thickness: 0.1 µm.

A diamond-like carbon (DLC) coating layer was further formed covering the upper face of the tungsten carbide layer by sputtering. The sputtering conditions were as follows. A DLC sample: a solid carbon target, an atmosphere: an argon gas atmosphere, a film formation temperature: 200 to 300°C, a film formation time: 150 minutes, and a film thickness: 1 µm. Thus, the formation of the gravure printing roll (gravure cylinder) was completed.

Water-based ink was applied to the above-mentioned gravure cylinder, and a printing test was performed using Oriented Polypropylene Film (OPP: biaxialy stretched polypropylene film) (printing rate of 100 m/minute, OPP film length of 4,000 m). With respect to the obtained printed substance, no fogging occurred and the ink transferability was excellent. The results confirmed that the diamond-like carbon (DLC) coating layer had performance comparable to that of the conventional chromium layer, and was satisfactorily used as a substitute for a chromium layer.

Moreover, it was confirmed that even if the gravure cylinder having a gravure cell with an extremely shallow depth was used, necessary printing density (optical density, transmittance density) was secured (2.00 in terms of an OD value), the hiding properties were improved; the film thickness of ink was small and therefore the drying load is small, whereby the ink amount was reduced and the printing cost was reduced.

### (Example 2)

A hollow roll forming gravure cells having a depth of 8 µm was produced in the same way as Example 1. A gravure printing roll was completed by treating in the same way as Example 1 except that the tungsten (W) sample was changed to a silicon (Si) sample with respect to the hollow roll. A printing test was conducted in the same way as Example 1, and a printed substrate having no fogging and excellent ink transferability was obtained. In this Example, it was also confirmed that the diamond-like carbon (DLC) coating layer had performance comparable to that of the conventional chromium layer, and was satisfactorily used as a substitute for a chromium layer. In addition, the same results as in Example 1 above were obtained for other printing performances. It should be noted that the same experiment was performed using titanium (Ti) and chromium (Cr) as metal samples, and it was confirmed that the same results were obtained.

## Claims

1. A gravure printing roll, comprising:
a hollow roll,
a copper plating layer which is formed on a surface of the hollow roll and a surface of which has a large number of gravure cells; and
a diamond-like carbon coating layer covering the surface of the copper plating layer, wherein
a depth of the gravure cell coated with the diamond-like carbon coating layer is 5 µm or more and less than 10 µm.

2. A gravure printing roll, comprising:
a hollow roll;
a copper plating layer which is formed on a surface of the hollow roll and a surface of which has a large number of gravure cells;
a metal layer formed on a surface of the copper plating layer,
a metal carbide layer formed on a surface of the metal layer, the metal of the metal carbide being of the same metal as that of the metal layer; and
a diamond-like carbon coating layer covering a surface of the metal carbide layer, wherein
a depth of the gravure cell coated with the diamond-like carbon coating layer is 5 µm or more and less than 10 µm.

3. A gravure printing roll according to claim 2, wherein the metal carbide layer is a metal carbide inclined layer, and a composition ratio of carbon in the metal carbide inclined layer is set so that a proportion of carbon increases gradually in a direction of the diamond-like carbon coating layer from the metal layer side.

4. A gravure printing roll according to claim 2 or 3, wherein a thickness of the copper plating layer is 50 to 200 µm, a thickness of the metal layer is 0.001 to 1 µm, a thickness of the metal carbide layer is 0.1 to 1 µm, and a thickness of the diamond-like carbon coating layer is 0.1 to 2 µm.

5. A gravure printing roll according to any one of claims 2 to 4, wherein the metal is capable of being carbonated and has high compatibility with copper.

6. A gravure printing roll according to any one of claims 2 to 5, wherein the metal is one kind or two or more kinds of metals selected from the group consisting of tungsten (W), silicon (Si), titanium (Ti), chromium (Cr), tantalum (Ta), and zirconium (Zr).

7. A method of manufacturing a gravure printing roll, comprising the steps of:
preparing a hollow roll;
forming a copper plating layer on a surface of the hollow roll;
forming a large number of gravure cells on a surface of the copper plating layer; and
forming a diamond-like carbon coating layer on the surface of the copper plating layer, wherein
a depth of the gravure cell coated with the diamond-like carbon coating layer is 5 µm or more and less than 10 µm.

8. A method of manufacturing a gravure printing roll, comprising the steps of:
preparing a hollow roll;
forming a copper plating layer on a surface of the hollow roll;
forming a large number of gravure cells on a surface of the copper plating layer;
forming a metal layer on the surface of the copper plating layer;
forming a metal carbide layer on a surface of the metal layer, the metal of the metal carbide being of the same metal as that of the metal layer; and
forming a diamond-like carbon coating layer covering a surface of the metal carbide layer, wherein
a depth of the gravure cell coated with the diamond-like carbon coating layer is 5 µm or more and less than 10 µm.

9. A method of manufacturing a gravure printing roll according to claim 8, wherein the metal carbide layer is a metal carbide inclined layer, and a composition ratio of carbon in the metal carbide inclined layer is set so that a proportion of carbon increases gradually in a direction of the diamond-like carbon coating layer from the metal layer side.

10. A method of manufacturing a gravure printing roll according to claim 8 or 9, wherein a thickness of the copper plating layer is 50 to 200 µm, a thickness of the metal layer is 0.001 to 1 µm, a thickness of the metal carbide layer is 0.1 to 1 µm, and a thickness of the diamond-like carbon coating layer is 0.1 to 2 µm.

11. A method of manufacturing a gravure printing roll according to any one of claims 8 to 10, wherein the metal layer, the metal carbide layer, and the diamond-like carbon coating layer are formed by sputtering, respectively.

12. A method of manufacturing a gravure printing roll according to any one of claims 8 to 11, wherein the metal is capable of being carbonated and has high compatibility with copper.

13. A method of manufacturing a gravure printing roll according to any one of claims 8 to 12, wherein the metal is one kind or two or more kinds of metals selected from the group consisting of tungsten (W), silicon (Si), titanium (Ti), chromium (Cr), tantalum (Ta), and zirconium (Zr).

14. A method of manufacturing a gravure printing roll according to any one of claims 7 to 13, wherein the gravure cells are formed by etching or electronic engraving.
